# EUROPEAN PATENT APPLICATION

(11) **EP 2 178 113 A1**
(43) Date of publication of application: **21.04.2010**
(21) Application number: 08290972.2
(22) Date of filing: 15.10.2008
(51) Int. Cl.: H01L 21/48, H01L 21/68

(54) **Electronic component and method of manufacturing the same**

(71) Applicant: NXP B.V., 5656 AG Eindhoven (NL)
(72) Inventor: Pommier, Mickael, 14000 Caen (FR); Yannou, Jean-Marc, 14610 Colomby sur Thaon (FR)
(74) Representative: Vignesoult, Serge L. M.

(57) **Abstract**

A method of forming an electronic component, comprises mounting an IC (16) on a first side of a substrate (14) which has vias (40) extending partially through the substrate. An encapsulation layer (30) is formed over the IC and a portion of the substrate is then removed a portion of the substrate such that the vias (40) extend through the reduced thickness substrate. A signal redistribution layer (32) is applied and an arrangement of connection elements (26), thereby forming a component for PCB mounting.

The signal redistribution layer enables fan out connections to be made. In this way, the size of the substrate is optimized based on the components to be mounted (the IC and passive components). Similarly, the size of the redistribution layer is optimized for the PCB to which the component is to be attached.

## Description

This invention relates to integrated circuits which use through silicon vias (TSVs).

A through-silicon via (TSV) is a vertical electrical connection passing completely through a silicon wafer or die. TSV technology is important in creating 3D packages and 3D integrated circuits.

A 3D package (otherwise known as a System in Package) contains two or more chips (integrated circuits) stacked vertically so that they occupy less space, but they behave as a single device. In most 3D packages, the stacked chips are wired together along their edges; this edge wiring slightly increases the length and width of the package and usually requires an extra "interposer" layer between the chips.

In some new 3D packages, through-silicon vias replace edge wiring by creating vertical connections through the body of the chips. The resulting package has no added length or width. Such a package is called a wafer level package (WLP). By using TSV technology, 3D ICs can pack a great deal of functionality into a small "footprint." In addition, critical electrical paths through the device can be drastically shortened, leading to faster operation.

A top IC may be mounted on an interposer upon which pads or balls are formed, as in flip chip ball grid array (BGA) packaging. When an interposer is used, a problem arises in forming the TSV through the interposer. The interposer can be a silicon substrate, and this needs to be thick for packaging robustness, which in turn means that high aspect ratio vias are required. This means it is difficult to fill the vias with the required conformal dielectric, seed layer and copper plug.

The silicon interposer needs to be sized to be filled with the desired passive components, but also needs to match the package substrate size. These size constraints may be incompatible.

According to the invention there is provided a method of forming an electronic component, comprising:
mounting an IC on a first side of a substrate which has vias extending partially through the substrate from the first side;
forming an encapsulation layer over the IC;
removing a portion of the substrate from the second side, such that the vias extend through the reduced thickness substrate;
applying a signal redistribution layer to the second side of the substrate; and
applying an arrangement of connection elements to the redistribution layer, thereby forming a component for PCB mounting.

This method provides an IC on a substrate. The substrate functions as an interposer, and can carry passive circuit components in addition to the IC. The encapsulation layer provides rigidity which enables the substrate to be thinned, and this thinning process completes the via formation. After thinning, a redistribution layer is added. This redistribution layer enables fan out connections to be made. In this way, the size of the substrate is optimized based on the components to be mounted (the IC and passive components). Similarly, the size of the redistribution layer is optimized for the PCB to which the component is to be attached. If desired, the component can be made with no wire bonds.

The substrate is preferably made of silicon, and the vias are thus TSVs.

The method can further comprise a first step of reducing the substrate thickness before forming the encapsulation layer. The substrate can be mounted on a foil before forming the encapsulation layer.

The IC is preferably mounted using a flip chip bumping technique. The encapsulation layer can comprise an epoxy resin mould.

The signal redistribution layer enables fan out connection to be made, and can comprise a copper and polyimide redistribution layer.

A second IC can be mounted on the redistribution layer. In this way, ICs are provided above and below the middle substrate, and a 3D integrated IC stack is formed. The second IC can also be mounted by flip chip bonding.

The method can be used to form multiple components with shared processing steps. In one example:
a plurality of ICs are mounted on the first side of the substrate;
the substrate is divided into portions before encapsulation;
the redistribution layer covers the multiple substrate portions; and
the structure is divided into electronic components after application of the connection element arrangement.

The invention also provides an electronic component, comprising:
an IC mounted on a first side of a substrate which has vias extending through the substrate;
an encapsulation layer over the IC and substrate;
a signal redistribution layer beneath the substrate; and
a connection element arrangement on the underside of the redistribution layer, thereby forming a component for PCB mounting.

An example of the invention will now be described in detail with reference to the accompanying drawings, in which:
Figure 1 shows a known electronic component;
Figure 2 shows an example of electronic component of the invention;
Figure 3 shows a first set of processing steps of a method of the invention; and
Figure 4 shows a second set of processing steps of a method of the invention.

The invention provides an electronic component, in which the vias of an interposer layer are formed by a thinning process, and an encapsulation layer is used over the interposer. A signal redistribution layer beneath the interposer provides fan-out connections, with an arrangement of connection elements (e.g. solder balls) on the underside of the redistribution layer for PCB mounting.

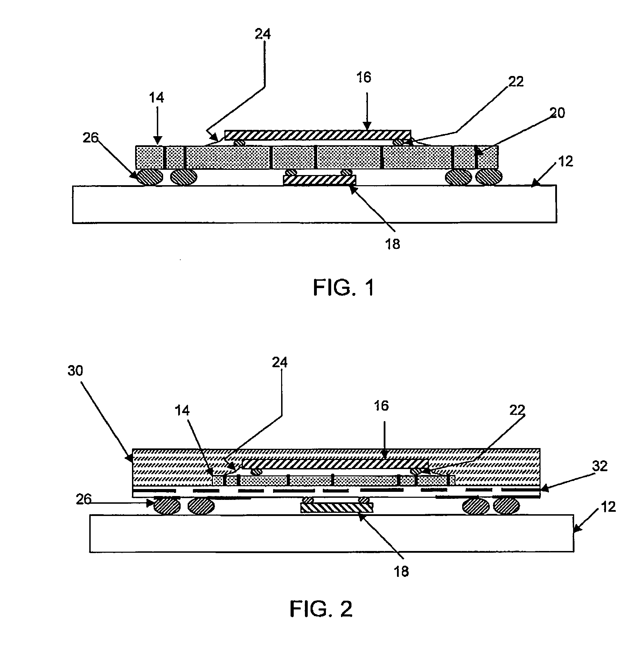

Figure 1 shows a known arrangement which provides vertical stacking of two ICs as a package which is mounted on a PCB 12.

The package comprises a central substrate 14, which is used to provide the integration of the two ICs 16 and 18. The substrate 14 also carries passive components.

The substrate 14 is made on silicon at the wafer level, and is provided with vias 20 which provide connection passageways for the pins of the IC 16 to the opposite side, as well as required connections to the passive circuit components.

The first IC 16 is mounted on top of the substrate 14 using silicon-silicon connection bumps 22, and an underfill layer 24 provides bonding of the IC to the substrate and thereby enhances the reliability of the silicon-silicon stack. The underfill layer also allows for the mounting of the IC 16 at the wafer level on the passive substrate, since the underfill prevents the sawing debris (when the individual substrates are cut from the wafer) from incurring electrical shorts between the bumps 22.

The underside of the substrate is provided with solder bumps 26 for PCB mounting. The vias thus provide a path between the top IC 16 and top-mounted passive components and the PCB, as well as providing paths between the two ICs.

A problem with the design of Figure 1 is that the substrate needs to be thick enough to support the two ICs and to be moved around the production facility. This means the vias need to have high aspect ratios (i.e. they need to have large openings), making it difficult to fill them with conformal dielectric, seed layer and copper plug.

Figure 2 shows an example of electronic component of the invention.

The substrate 14, and the top IC 16 is provided in an encapsulation layer 30 over the IC and substrate. A signal redistribution layer 32 is provided beneath the substrate, and the solder bumps 26 for PCB mounting are provided on the lower surface of the redistribution layer 32.

As will be explained below, the use of the encapsulation layer enables the substrate to be thinner, and this means the vias can be formed more easily. The substrate 14 can be smaller, as it no longer has to be matched to the PCB area to which it will be connected. Instead, the size of the substrate can be optimized for the circuit components to be carried by it. Thus, the substrate size is not dependent on the required input/output interface to the PCB.

The encapsulation layer also provides a support surface which assists in the back side processing of the substrate (i.e. the bottom face), in particular, the application of the redistribution layer. The top face of the substrate and the first IC are protected by the encapsulation layer during this process.

The encapsulation layer also provides a regular profile for the completed component, which enables simple pick and place processing by the end user when attaching the component to a PCB.

The attachment of the solder balls to the redistribution layer can also have improved reliability compared to the provision of solder balls directly on silicon.

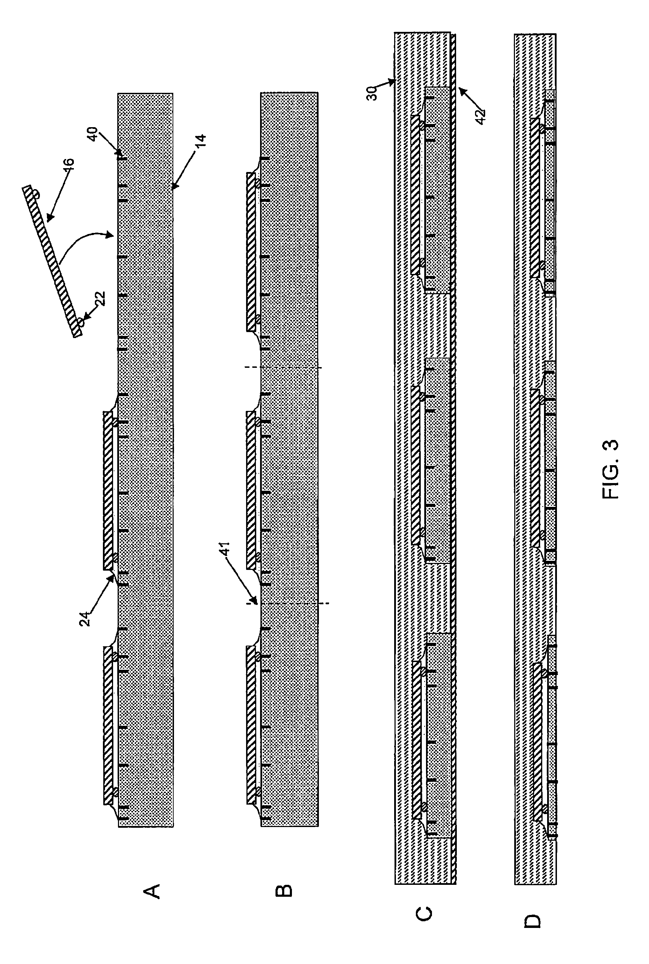

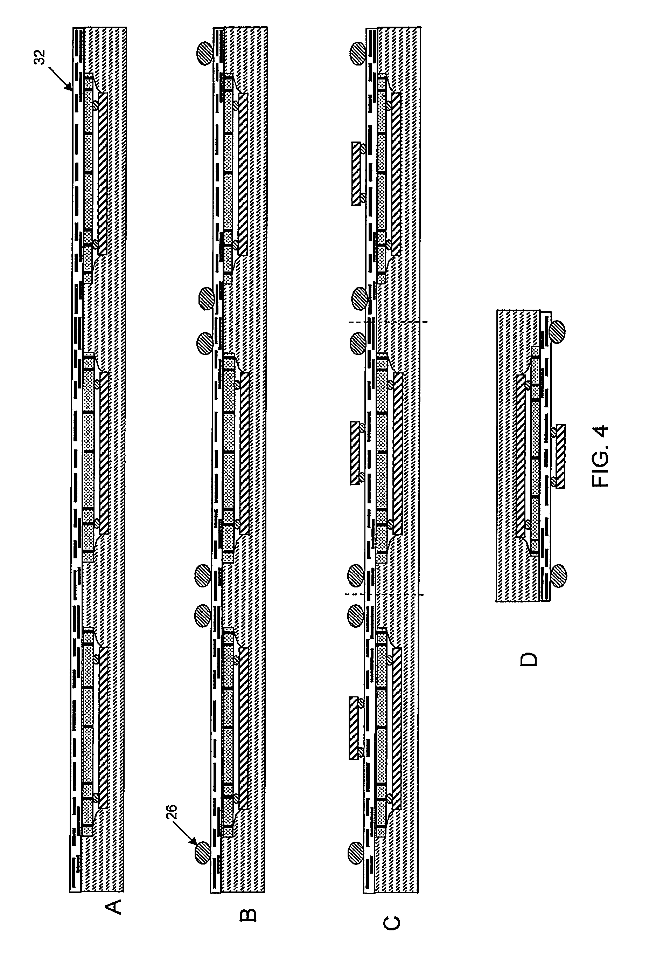

Figures 3 and 4 show the processing steps of a method of the invention. The method is for processing multiple components using shared processing steps. The sequence of batch operations can be carried out at the wafer level, using known IC manufacturing equipment.

Figure 3A shows the placement of the first ICs 16 on the thick passive integration substrate, which has vias 40 on the top surface, which extend only partially into the depth of the substrate. The vias are filled with copper, and have an aspect ratio of for example 2 to 3. The placement can be by standard pick, flip and placement equipment, forming part of standard chip to wafer assembly techniques.

The substrate 14 is partially ground, for example to 200µm. Figure 3B shows the sawing of the substrate along saw lines 41 to create individual components.

These are mounted on a wafer shaped foil 42 in a desired configuration, then covered with the encapsulation layer 30 as shown in Figure 3C. This is a wafer molding process. The mould is an expoxy mould, which offers rigidity for the substrate to be thinned further as shown in Figure 3D after removal of the foil 42. The final thickness of the component (epoxy resin + substrate + redistribution layer, but not the solder balls to the PCB) can be between 100µm and 600µm. The final thickness of the silicon substrate 14 is between 20µm and 100µm. This thinning of the substrate results in the vias extending fully through the substrate.

The arrangement is then turned upside down and the signal redistribution layer 32 is applied, as shown in Figure 4A. This is a copper and polyimide structure which provides horizontal fan out paths.

Further wafer level processing is applied, such as solder ball placement (Figure 4B) and placement of the second ICs 18 by flip chip bonding (Figure 4C).

Finally, the stacks are divided into single units, along the dotted lines 42 shown in Figure 4C, and the individual components (one of which is shown in Figure 4D) are then tested and marked. The final components are 3D integrated stacks with no wire bonds, and processed using a combination of front-end and back-end processes and materials.

The method of the invention provides a process flow in which the formation of the silicon interposer substrate is integrated with the circuit assembly operations, providing an optimized process flow, which combines front-end and back-end operations. The processes can be implemented in a front-end (wafer fabrication) facility.

The redistribution layer can be implemented as a stack of dielectric layers and interposed metal track layers. The metal tracks can be sputtered or electroplated copper. The dielectric layers can be polyimide or BCB. According to the required routing density, several layers can be stacked on top of one another. Each layer offers a very high routing density, compared to traditional organic substrates: the pitch between two metal layers can be made as small as 5µm. The copper layers may have varying thicknesses from 1µm to 10µm.

The use of epoxy resin for encapsulation is well known. The resin can be loaded with varying ratios of silica, with silica grains of varying diameters, to vary the material properties.

The process to form the partial vias, before the grinding step, is conventional, and is known as a "via-first" flow. This involves: photolithographic masking, followed by deep reactive ion etching (Bosch process), and thermal oxidation. A seed layer is then sputtered, and copper electroplating is carried out to fill in the via plugs. Photolithographic masking and etching of the copper and seed layer is then used to remove those layers where they are not needed.

The rest of the process flow involves making passive components, then, processing the electrical routing paths with metal and dielectric stacks, and then passivation.

The example above uses solder bumps as the connection elements, but copper pillars can be used. Wire bonds may also be used, in which case the device is placed with the epoxy cap face down, and the device can be wire bonded to the PCB using bond pads on the redistribution layer (with no second ICs 18 present).

The resulting electronic component can be used in a variety of applications:
- applications where size matters: medical applications (for example with ASlCs and decoupling capacitors in the substrate), industrial applications, aerospace applications, and for mobile communications systems (RF transceivers, baseband ICs).
- application where higher routing density PCBs are needed due to the ever increasing input/Output count, and where decoupling as close to the IC as possible is desired, so as to enable high frequency operations: graphical processing units (GPU's), FPGA's, microprocessors.

In the example above, a single IC 16 is shown mounted on the redistribution layer. Of course, multiple ICs may be provided on top of the signal redistribution layer and/or multiple ICs can be provided on the underside of the signal redistribution layer.

Various modifications will be apparent to those skilled in the art.

## Claims

1. A method of forming an electronic component, comprising:
mounting an IC (16) on a first side of a substrate (14) which has vias (40) extending partially through the substrate from the first side;
forming an encapsulation layer (30) over the IC;
removing a portion of the substrate from the second side, such that the vias (40) extend through the reduced thickness substrate;
applying a signal redistribution layer (32) to the second side of the substrate; and
applying an arrangement of connection elements (26) to the redistribution layer, thereby forming a component for PCB mounting.

2. A method as claimed in claim 1, wherein the substrate (14) is made of silicon.

3. A method as claimed in any preceding claim, further comprising a first step of reducing the substrate thickness before forming the encapsulation layer (30).

4. A method as claimed in any preceding claim, further comprising mounting the substrate (14) on a foil (42) before forming the encapsulation layer.

5. A method as claimed in any preceding claim, wherein the IC (16) is mounted using a flip chip bumping technique.

6. A method as claimed in any preceding claim, wherein the encapsulation layer (30) comprises an epoxy resin mould.

7. A method as claimed in any preceding claim, wherein the signal redistribution layer (32) comprises a copper and polyimide redistribution layer.

8. A method as claimed in any preceding claim, further comprising mounting a second IC (18) on the signal redistribution layer (32).

9. A method as claimed in claim 8, wherein the second IC (18) is mounted by flip chip bonding.

10. A method as claimed in any preceding claim, further comprising mounting the component on a PCB (12).

11. A method as claimed in any preceding claim, wherein:
a plurality of ICs (16) are mounted on the first side of the substrate (14);
the substrate (14) is divided into portions before encapsulation;
the signal redistribution layer (32) covers the multiple substrate portions; and
the structure is divided into electronic components after application of the connection element arrangement (26).

12. An electronic component, comprising:
an IC mounted (16) on a first side of a substrate (14) which has vias (40) extending through the substrate;
an encapsulation layer (30) over the IC and substrate;
a signal redistribution layer (32) beneath the substrate (14); and
a connection element arrangement (26) on the underside of the signal redistribution layer (32), thereby forming a component for PCB mounting.

13. A component as claimed in claim 12, wherein the substrate (14) is made of silicon.

14. A component as claimed in claim 12 or 13, wherein the encapsulation layer (300 comprises an epoxy resin mould.

15. A component as claimed in any one of claims 11 to 14, further comprising a second IC (18) mounted on the signal redistribution layer (32) on the same side as the connection element arrangement.
